**Europäisches Patentamt**

**European Patent Office**

**Office européen des brevets**

(19)

(11) Veröffentlichungsnummer: **0 080 726**
**A1**

(12) # EUROPÄISCHE PATENTANMELDUNG

(21) Anmeldenummer: 82111017.8

(22) Anmeldetag: 29.11.82

(51) Int. Cl.³: **H 03 K 3/288**
**H 03 K 3/013**

(30) Priorität: 01.12.81 DE 3147547

(43) Veröffentlichungstag der Anmeldung:
08.06.83 Patentblatt 83/23

(84) Benannte Vertragsstaaten:
FR GB NL

(71) Anmelder: **SIEMENS AKTIENGESELLSCHAFT**
**Berlin und München Wittelsbacherplatz 2**
**D-8000 München 2(DE)**

(72) Erfinder: **Barré, Claude**
**Schwanthalerstrasse 99**
**D-8000 München 2(DE)**

(54) Durch einen Übernahmetakt gesteuertes Flipflop in Stromumschaltetechnik.

(57) Zur Vermeidung von Störimpulsen, die am Ende eines Taktimpulses beim tiefen Signalpegel am Ausgang eines taktgesteuerten Flipflops in ECL-Technik mit Serienkopplung entstehen, wird dem während eines Taktimpulses an sich stromlos geschalteten Differenzverstärker ein Hilfsstrom zugeführt, der klein gegen den geschalteten Hauptstrom ist. Dadurch kann sich dieser Differenzverstärker schon vor dem Ende des Taktimpulses auf den jeweils richtigen Schaltzustand einstellen.

FIG 2

**EP 0 080 726 A1**

Croydon Printing Company Ltd.

SIEMENS AKTIENGESELLSCHAFT     Unser Zeichen
Berlin und München     VPA 81 P 2090 E

**Durch einen Übernahmetakt gesteuertes Flipflop in Stromumschaltetechnik.**

Die Erfindung bezieht sich auf ein Flipflop gemäß dem Oberbegriff des Patentanspruchs 1.

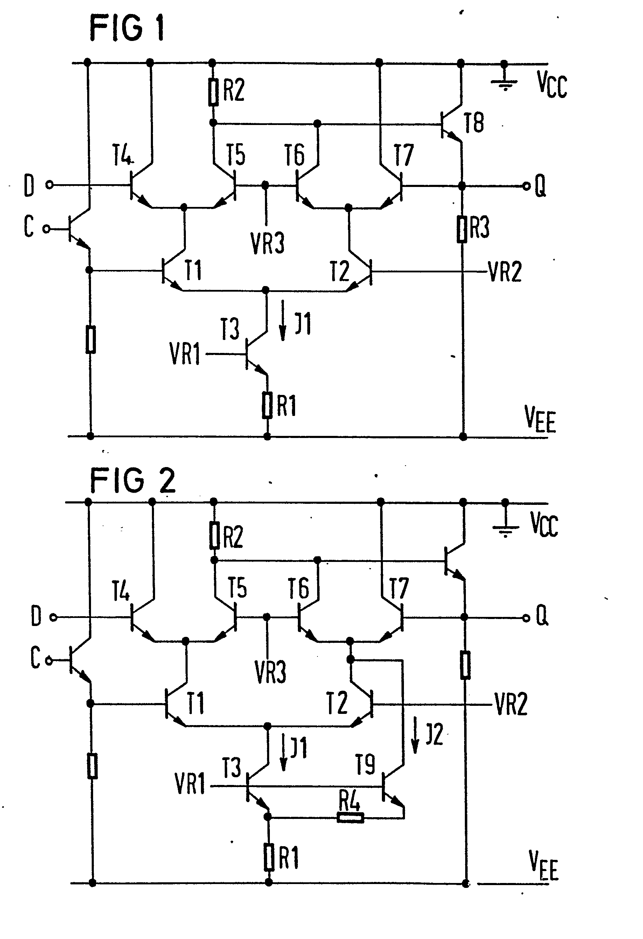

Bei Flipflop-Schaltungen, die auf der Grundlage der Stromumschaltetechnik (ECL, CML) aufgebaut sind, wird häufig von dem Schaltungsprinzip Serienkopplung oder serielle Verknüpfung Gebrauch gemacht (vergleiche "Der Fernmeldeingenieur", 27, H. 7, Juli 1973, Seite 19 und 20). Ein bekanntes taktgesteuertes D-Flipflop dieser Art, auf das im folgenden Bezug genommen wird, ist zum besseren Verständnis der Erfindung, auf die später eingegangen wird, in Fig. 1 der Zeichnung dargestellt.

Ein erster Differenzverstärker mit den emittergekoppelten Transistoren T1 und T2 wird durch eine Konstantstromquelle aus dem Transistor T3 mit an einem ersten Referenzpotential VR1 liegender Basis und einem Emitterwiderstand R1 gebildet. An der Basis des ersten Transistors T1 liegt das mit Hilfe eines Emitterfolgers pegelverschobene Taktsignal C an. Die Basis des zweiten Transistors T2 des ersten Differenzverstärkers ist an ein zweites Referenzpotential VR2 angeschlossen.

Mit dem Kollektor des Transistors T1 im ersten Differenzverstärker sind die Emitter von zwei Transistoren T4 und T5 eines zweiten Differenzverstärkers verbunden. Die Basis des Transistors T4 bildet den Dateneingang D für die in das Flipflop einzugebende Information. Die Basis des Transistors T5 liegt an einem dritten Referenzpotential VR3.

She 1 Fdl/12. 10. 1981

0080726

VPA 81 P 2 0 9 0 E

Ein dritter Differenzverstärker mit den Transistoren T6 und T7 ist im Kollektorstromkreis des zweiten Transistors T2 im ersten Differenzverstärker angeordnet. Der Transistor T6, dessen Basis ebenfalls mit dem dritten Referenzpotential VR3 verbunden ist, besitzt einen gemeinsamen Arbeitswiderstand R2 mit dem Transistor T5 des zweiten Differenzverstärkers. Der entsprechend dem jeweiligen Schaltzustand des Flipflops bzw. der eingespeicherten Information an dem Arbeitswiderstand R2 entstehende oder nicht vorhandene Spannungsabfall bestimmt letztlich den binären Wert des am Ausgang Q des Flipflops abgreifbaren, durch einen Emitterfolger mit dem Transistor T8 und dem Emitterwiderstand R3 zusätzlich pegelverschobenen Ausgangssignals. Die für das bistabile Verhalten der Schaltungsanordnung erforderliche Signalrückführung geschieht vom Ausgang Q auf die Basis des Transistors T7 im dritten Differenzverstärker.

Ein (positiver) Impuls am Takteingang C steuert den Transistor T1 leitend. Liegt gleichzeitig am Dateneingang D ein binäre "1" an, dann fließt der von der Konstantstromquelle gelieferte Strom I1 durch den Transistor T4. Die Transistoren T2 und T5 sind gesperrt. Damit ist der Arbeitswiderstand R2 stromlos und der Ausgang Q führt den binären Wert "1".

Mit dem Ende des Taktimpulses am Eingang C geht der Transistor T1 in den Sperrzustand über und der Transistor T2 wird leitend. Gleichzeitig wird auch der Transistor T7 leitend, während der Transistor T6 stromlos bleibt. Damit ändert sich auch der Signalpegel am Ausgang Q nicht. Die am Dateneingang D anliegende Information ist bleibend eingespeichert. Eine zwischen zwei Impulsen des Übernahmetaktes gegebenenfalls eintretende Veränderung des Signalpegels am Dateneingang D kann sich nicht auswirken, weil der zweite Differenzverstärker mit den Transistoren T4 und T5 wegen der
Sperrung des Transistors T1 insgesamt stromlos ist.

Die Eingabe einer am Dateneingang D anliegenden binären
"0" durch einen weiteren Impuls läuft im Prinzip in der
gleichen Weise ab, wie die beschriebene Eingabe einer
binären "1". Selbstverständlich ist nunmehr zunächst der
Transistor T4 im zweiten Differenzverstärker gesperrt
und der Transistor T5 leitend. Am Arbeitswiderstand R2
entsteht ein Spannungsabfall und der Ausgang Q führt
den tieferen Signalpegel entsprechend einer binären
"0". Damit wird bei der Übernahme des Speisestroms I1
durch den Transistor T2 am Ende des Taktimpulses des
Transistor T6 im dritten Differenzverstärker leitend,
so daß am Ausgang Q des Flipflops weiterhin der binäre
Signalwert "0" abgreifbar ist.

Die Übergabe einer zu speichernden binären "0" vom
zweiten in den dritten Differenzverstärker erfolgt jedoch nicht völlig störungsfrei. Vielmehr entsteht am
Ausgang Q ein kurzer positiver Impuls (spike) mit einer
mehr oder weniger großen Amplitude. Der Grund·dafür besteht darin, daß der Strom durch den Transistor T5
schneller abnimmt, als der Strom durch den Transistor T6
ansteigt. Die Summe der Teilströme bleibt damit nicht
konstant.

Ein Störimpuls am Ausgang Q kann jedoch nicht nur zu einer
falschen Reaktion nachfolgender Schaltungsanordnungen
führen, sondern er kann sogar ein Fehlverhalten des
Flipflops, d. h. einen Datenverlust hervorrufen.

Der Erfindung liegt die Aufgabe zugrunde, durch entsprechende Schaltungsmaßnahmen solche Störimpulse ganz
zu vermeiden oder mindestens ihre Amplitude auf ein unschädliches Maß zu beschränken. Gemäß der Erfindung wird diese Aufgabe durch die Merkmale im kennzeichnenden Teil des Patentanspruchs 1 gelöst.

Im folgenden wird die Erfindung anhand eines in Fig. 2 der Zeichnung dargestellten Ausführungsbeispieles näher beschrieben. Ein Vergleich zwischen den Schaltungsanordnungen nach Fig. 1 und 2 läßt eine weitgehende Übereinstimmung erkennen, die auch durch die gleiche Bezeichnung für einander entsprechende Bauelemente deutlich wird.

Indessen ist bei der Ausführungsform nach Fig. 2 erfindungsgemäß eine Hilfsstromquelle zur Lieferung eines Hilfsstroms I2 vorgesehen für die Stromversorgung des dritten Differenzverstärkers mit den Transistoren T6 und T7 auch dann, wenn der Transistor T2 des ersten Differenzverstärkers während der Dauer eines Taktimpulses des Übernahmetakts gesperrt ist. Die an die Emitter der Transistoren T6 und T7 des dritten Differenzverstärkers angeschlossene Hilfsstromquelle besteht nach Fig. 2 aus dem Transistor T9 und dem Emitterwiderstand R4. Die Basis des Transistors T9 liegt an dem Referenzpotential VR1. Durch eine entsprechende Bemessung des Widerstands R4, der mit dem Emitter des Transistors T3 der Hauptstromquelle oder mit dem Betriebsspannungsanschluß $V_{EE}$ verbunden sein kann, wird der von der Hilfsstromquelle gelieferte Strom I2 so eingestellt, daß er etwa 5 % bis 10 % des Stroms I1 aus der Hauptstromquelle T3, R1 beträgt. In an sich bekannter Weise kann die Hilfsstromquelle auch durch einen zwischen den Emittern der Transistoren T6 und T7 des dritten Differenzverstärkers und dem Betriebsspannungsanschluß $V_{EE}$ eingefügten Widerstand ersetzt werden.

Durch die Einspeisung des Hilfsstroms I2 wird erreicht, daß der dritte Differenzverstärker schon während der Dauer des Taktimpulses, genauer ausgedrückt, sobald sich die am Dateneingang D anliegende Information auf den Ausgang Q durchgesetzt hat, in einen eindeutigen und zwar in den richtigen Schaltzustand versetzt wird. Es steht also bereits vor dem Ende eines Taktimpulses und damit vor der Übernahme des Hauptstroms I1 durch den Transistor T2 im ersten Differenzverstärker fest, welcher der beiden Transistoren T6 oder T7 im dritten Differenzverstärker leitend bzw. gesperrt ist. Die Kontinuität des Stromflusses durch den Arbeitswiderstand R2 hängt also nur noch von dem Verlauf der Stromübernahme im ersten Differenzverstärker ab. Im allgemeinen treten keine nennenswerten Abweichungen auf. Die Amplitude von gegebenenfalls noch entstehenden Störimpulsen ist wesentlich kleiner als der halbe Signalhub und somit unschädlich.

In diesem Zusammenhang ist auf die aus Fig. 2 ersichtliche Auslegung der Hilfsstromquelle, bei der der Emitterwiderstand R4 des Transistors T9 mit dem Emitter des Transistors T3 der Hauptstromquelle verbunden ist, besonders hinzuweisen. Erreicht nämlich während der Umschaltphase die Summe der durch die Transistoren T1 und T2 des ersten Differenzverstärkers fließenden, sich rasch ändernden Teilströme nicht in jedem Augenblick den normalen Wert I1 des Hauptstroms, dann verringert sich nicht nur der Spannungsabfall über dem Arbeitswiderstand R2, sondern auch der Spannungsabfall über dem Widerstand R1 der Hauptstromquelle vorübergehend. Dementsprechend steigt der Hilfsstrom I2 an und liefert damit einen verstärkten Beitrag zum Spannungsabfall am Arbeitswiderstand R2.

Abschließend sei noch erwähnt, daß die Transistoren T5 und T6 durch einen Transistor mit zwei Emittern ersetzbar sind. Dieser Austausch ist ohne funktionelle Wirkung möglich, weil sowohl die Basiselektroden der Transistoren T5 und T6 als auch ihre Kollektoren jeweils

0080726
VPA 81 P 2 0 9 0 E

miteinander verbunden sind.

2 Figuren
4 Patentansprüche

0080726

## Patentansprüche

1. Durch einen Übernahmetakt gesteuertes Flipflop in Stromumschaltetechnik mit einem durch eine Hauptstromquelle gespeisten ersten Differenzverstärker mit emittergekoppelten Transistoren, in deren Kollektorkreisen ein zweiter und dritter Differenzverstärker angeordnet sind, wobei an der Basis des ersten Transistors der Übernahmetakt anliegt und die Basis des zweiten Transistors mit einem festen Referenzpotential verbunden ist, d a d u r c h   g e k e n n z e i c h n e t, daß dem mit dem Kollektor des zweiten Transistors (T2) verbundenen dritten Differenzverstärker (T6, T7) ein von einer Hilfsstromquelle erzeugter Hilfsstrom (I2) eingeprägt wird, dessen Stärke 5 % bis 10 % des von der Hauptstromquelle gelieferten Hauptstroms (I1) beträgt.

2. Flipflop nach Anspruch 1, d a d u r.c h   g e k e n n - z e i c h n e t, daß die Hauptstromquelle und die Hilfsstromquelle als Konstantstromquellen ausgebildet sind mit je einem Transistor (T3 bzw. T9) und mit je einem zugehörigen Emitterwiderstand (R1 bzw. R4), wobei die Basiselektroden der Transistoren (T3, T9) mit einem gemeinsamen Referenzpotential (VR1) verbunden sind.

3. Flipflop nach Anspruch 2, d a d u r c h   g e k e n n - z e i c h n e t, daß der Emitterwiderstand (R4) für den Transistor (T9) der Hilfsstromquelle mit dem Emitter des Transistors (T3) der Hauptstromquelle verbunden ist.

4. Flipflop nach Anspruch 2, d a d u r c h   g e k e n n - z e i c h n e t, daß der Emitterwiderstand (R4) für den Transistor (T9) der Hilfsstromquelle mit dem emitterseitigen Betriebsspannungsanschluß ($V_{EE}$) verbunden ist.

0080726

## FIG 1

## FIG 2

Europäisches
Patentamt

**EUROPÄISCHER RECHERCHENBERICHT**

**0080726**
Nummer der Anmeldung

EP 82 11 1017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| Y | IEEE JOURNAL OF SOLID-STATE CIRCUITS, Volume SC-15, Nr. 6, Dezember 1980, Seiten 1030 - 1032, NEW YORK (US). EMMERT et al., "A Versatile Bipolar Monolithic 6-bit A/D Converter for 100 MHz Sample Frequency"* Seite 1031, linke Spalte, Zeilen 11 - 18; Figur 2 * | 1,2,4 | H 03 K 3/288<br>H 03 K 3/013 |
| | --- | | |
| Y | DE-B-2 821 231 (SIEMENS A.G.) * von Spalte 3, Zeile 46 bis Spalte 4, Zeile 57; Figur 1 * | 1,2 | |
| | --- | | |
| A | EP-A-0 025 502 (IBM Corp.) * Seiten 8 - 10; Figur 4 * | 1 | |
| | --- | | RECHERCHIERTE SACHGEBIETE (Int. Cl. 3) |
| A | IBM Technical Disclosure Bulletin , Volume 14, Nr. 6, November 1971, Seite 1666, NEW YORK (USA). MOORE et al., "Fast NDRO memory circuits for integration"* Figur und Zeilen 5 -10 * | 1 | H 03 K |
| | ----- | | |

Der vorliegende Recherchenbericht wurde für alle Patentansprüche erstellt.

| Recherchenort DEN HAAG | Abschlußdatum der Recherche 09-03-1983 | Prüfer CANTARELLI R.J.H. |
|---|---|---|